# EUROPEAN PATENT APPLICATION

(11) **EP 2 395 574 A1**
(43) Date of publication of application: **14.12.2011**
(21) Application number: 10738628.6
(22) Date of filing: 02.02.2010
(51) Int. Cl.: H01L 51/50, G09F 9/30, H01L 27/32, H05B 33/10, H05B 33/12, H05B 33/22

(54) **DISPLAY DEVICE SUBSTRATE AND MANUFACTURING METHOD THEREFOR**

(30) Priority: 04.02.2009 JP 2009023473
(71) Applicant: Sumitomo Chemical Company, Limited, Tokyo 104-8260 (JP)
(72) Inventor: KAJITANI, Masaru, Niihama-shi Ehime 792-0025 (JP); KURIHARA, Takashi, Ehime 791-0526 (JP); NISHIOKA, Yukiya, Nara-shi Nara 631-0034 (JP)
(74) Representative: Jackson, Martin Peter
(86) International application number: PCT/JP2010/051736
(87) International publication number: WO 2010/090298

(57) **Abstract**

A display device substrate to be bonded to a driving substrate provided with a driving circuit for driving a plurality of organic electroluminescent elements, the display device substrate comprising a substrate main body; a plurality of organic electroluminescent elements provided on the substrate main body; a bank sectioning the plurality of organic electroluminescent elements on the substrate main body; a protruding pedestal provided on the substrate main body; and a first connecting electrode arranged so as to extend from the organic electroluminescent element and over the pedestal, wherein in a state where the display device substrate has been bonded to the driving substrate, the pedestal is arranged at a position where the first connecting electrode arranged on the pedestal is connected with a second connecting electrode that the driving circuit has, and the bank and the pedestal have the same height.

## Description

### Technical Field

The present invention relates to a display device substrate, a method for manufacturing the display device substrate, a display panel formed by bonding the display device substrate and a driving substrate together, and a display device comprising the display panel.

### Background Art

A display device including a plurality of organic electroluminescent elements (hereinafter, "electroluminescent" may be simply referred to as "EL") as light sources for pixels (hereinafter may be referred to as an "organic EL display device") displays predetermined image information by selectively driving each of the organic EL elements. An organic EL display device is realized by mounting a display panel, which is produced by bonding a display device substrate provided with a plurality of organic EL elements to a driving substrate provided with a driving circuit for selectively driving each of the organic EL elements, on a housing together with a speaker, a tuner, a driver, etc. (see Patent Document 1, for example).

In a display panel formed by bonding a display device substrate and a driving substrate together, a protruding first connecting electrode is provided on the display device substrate, and the first connecting electrode is brought into contact with a second connecting electrode in the driving substrate. Thus, electrical connection between organic EL elements in the display device substrate and a driving circuit in the driving substrate is secured. In the conventional art, the protruding first connecting electrode is formed by providing a protruding pedestal on the display device substrate and forming the first connecting electrode drawn from electrodes of the organic EL elements on the pedestal (see JP 2005-353600 A, for example).

### Disclosure of the Invention

To secure electrical connection between organic EL elements and a driving circuit, a first connecting electrode in a display device substrate needs to come into contact with a second connecting electrode in a driving substrate in a state where the display device substrate and the driving substrate have been bonded together. In the conventional art, to meet this need, a pedestal on which the first connecting electrode is to be formed is formed so as to protrude further than other structural objects in the display device substrate. Although the pedestal is formed by a vapor deposition method or photolithography, these methods have difficulty in forming structural objects having different heights at a single process. Accordingly, it is difficult to form the pedestal protruding further than other structural objects together with the other structural objects at a single process. Therefore, a process for forming a pedestal alone is necessary, which makes it difficult to simplify a process of manufacturing a display device substrate.

It is an object of the present invention to provide a display device substrate with a structure that can be manufactured by a simple process and a manufacturing method therefor.

The present invention relates to a display device substrate to be bonded to a driving substrate provided with a driving circuit for driving a plurality of organic electroluminescent elements, the display device substrate comprising:
a substrate main body;
a plurality of organic electroluminescent elements provided on the substrate main body;
a bank sectioning the plurality of organic electroluminescent elements on the substrate main body;
a protruding pedestal provided on the substrate main body; and
a first connecting electrode arranged so as to extend from the organic electroluminescent element and over the pedestal, wherein
in a state where the display device substrate has been bonded to the driving substrate, the pedestal is arranged at a position where the first connecting electrode arranged on the pedestal is connected with a second connecting electrode that the driving circuit has, and
the bank and the pedestal have the same height.

The present invention relates to the display device substrate, wherein
the pedestal is in a shape forward tapered in a direction away from the substrate main body, and
the bank is in a shape inversely tapered in a direction away from the substrate main body.

The present invention relates to a display panel comprising:
the display device substrate; and
a driving substrate provided with a driving circuit for driving the plurality of organic electroluminescent elements provided in the display device substrate, wherein
the displaying substrate and the driving substrate are bonded together so that the first connecting electrode may be connected with a second connecting electrode that the driving circuit has.

The present invention relates to a display device comprising the display panel.

The present invention relates to a method for manufacturing a display device substrate to be bonded to a driving substrate provided with a driving circuit for driving a plurality of organic electroluminescent elements, the method comprising:
a step of forming a bank and a pedestal comprising forming a bank and a protruding pedestal on the substrate main body, the bank being to section the plurality of organic electroluminescent elements on the substrate main body;
a step of forming the plurality of organic electroluminescent elements on the substrate main body; and
a step of forming a first connecting electrode extending from the organic electroluminescent element and over the pedestal, wherein
in the step of forming a bank and a pedestal forming step, the pedestal is formed at a position where the first connecting electrode arranged on the pedestal is connected with a second connecting electrode that the driving circuit has in a state where the display device substrate has been bonded to the driving substrate, the bank having the same height as the pedestal is formed, and the bank and the pedestal are formed by a single photolithography step.

The present invention relates to the method for manufacturing a display device substrate, wherein in the step of forming a bank and a pedestal, the pedestal is formed in a shape forward tapered in a direction away from the substrate main body, and the bank is formed in a shape inversely tapered in a direction away from the substrate main body.

The present invention relates to the method for manufacturing a display device substrate, wherein
the single photolithography step comprises a film forming step of applying a negative photosensitive resin composition onto the substrate main body to form a film, an exposing step of applying light to a portion where the bank is to be formed and a portion where the pedestal is to be formed, on the film formed in the film forming step, and a developing step, and
in the exposing step, the portion where the pedestal is to be formed is irradiated with larger amount of light than the portion where the bank is to be formed.

### Brief Description of the Drawings

FIG. 1 is a schematic sectional view of a portion of a display panel 1 in accordance with an embodiment of the present invention.
FIG. 2 is a schematic plan view of a portion of a display device substrate 30.

### Explanations of Letters or Numerals

- 1: display panel
- 20: driving substrate
- 21: transistor
- 23: wire
- 24: second connecting electrode
- 30: display device substrate
- 31: organic EL element
- 32: bank
- 33: first connecting electrode
- 34: pedestal
- 35: substrate main body
- 36: anode
- 37: cathode
- 38: light-emitting layer
- 39: hole injection layer
- 40: pixel area
- 41: conductive film

### Embodiments for Carrying Out the Invention

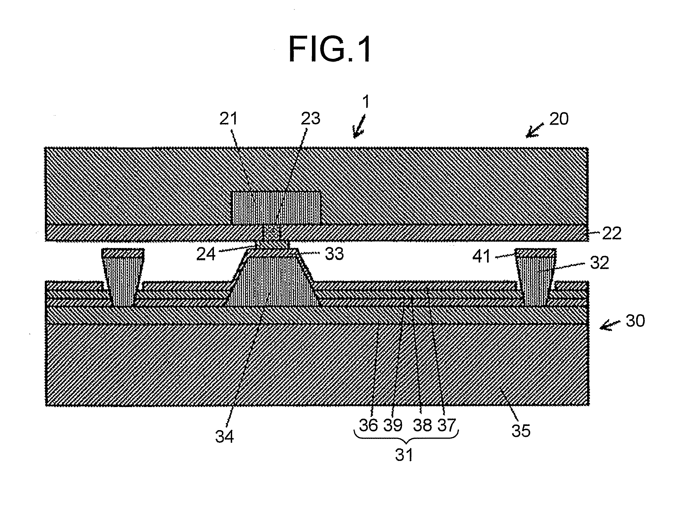

FIG. 1 is a schematic sectional view of a portion of a display panel 1 in accordance with an embodiment of the present invention. The display panel 1 includes a driving substrate 20 and a display device substrate 30 and is realized by bonding the driving substrate 20 and the display device substrate 30 together.

The driving substrate 20 is a substrate provided with a driving circuit for driving organic EL elements 31 and is realized with a TFT (Thin Film Transistor) substrate. The TFT substrate is formed using, for example, a silicon semiconductor such as a-Si (noncrystal silicon), p-Si (polycrystal silicon) and µ-Si (microcrystal silicon), and an oxide semiconductor. In the driving substrate 20, a transistor 21, a capacitor, a wire, and the like are formed as the driving circuit. In the present embodiment, an active matrix driving circuit for individually driving a plurality of organic EL elements is formed as the driving circuit in the driving substrate 20.

An insulating film 22 having electrical insulating properties is formed over the whole surface of the driving substrate 20.

A second connecting electrode 24 is formed on the surface of the insulating film 22. The second connecting electrode 24 is provided at a position coming into contact with a first connecting electrode 33 drawn from the organic EL element in a state where the driving substrate 20 and the display device substrate 30 have been bonded together. A through hole passing through the insulating film 22 in the thickness direction is formed. In the through hole, a wire 23 connecting between an output electrode of the transistor 21 and the second connecting electrode 24 is formed. Therefore, in a state where the driving substrate 20 and the display device substrate 30 have been bonded together, the output electrode of the transistor 21 and the organic EL element 31 are electrically connected through the wire 23, the second connecting electrode 24 and the first connecting electrode 24. The second connecting electrode 24 is arranged at a position overlapping with a pedestal 34 to be described later in a state where the driving substrate 20 and the display device substrate 30 have been bonded together.

The display device substrate 30 comprises a substrate main body 35, the organic EL elements 31 provided on the substrate main body 35, a bank 32 sectioning the organic EL elements, the protruding pedestal 34 provided on the substrate main body 35, and the first connecting electrode 33 arranged so as to extend from the organic EL element 31 and over the pedestal 34.

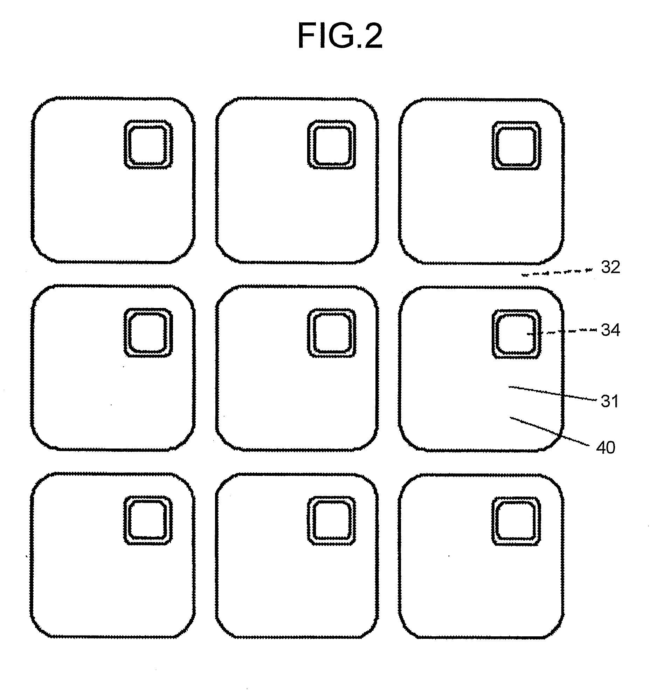

FIG. 2 is a schematic plan view of a portion of the display device substrate 30. In the present embodiment, the bank 32 is provided in a grid pattern in a plan view and sections each of organic EL elements 31 in a grid pattern. Each of the organic EL elements 31 is provided in an area 40 surrounded by the bank 32 (hereinafter may be referred to as a pixel area) and is arranged in a matrix form in a plan view. FIG. 2 illustrates nine organic EL elements 31 arrayed in three rows and three columns.

The bank 32 is formed on an electrode (an anode 36 in the present embodiment) of the organic EL element 31 formed over the whole surface of the substrate main body 35. In the present embodiment, the bank 32 is formed in a shape inversely tapered in a direction away from the substrate main body 35. In other words, the bank 32 is configured to widen as away from the substrate main body 35 (see FIG. 1).

The pedestal 34 is arranged at a position where the first connecting electrode 33 arranged on the pedestal 34 comes into contact with the second connecting electrode 24 that the driving circuit has in a state where the display device substrate 30 has been bonded to the driving substrate 20. The pedestal 34 is formed on the same surface on which the bank 32 is formed. In other words, the pedestal 34 is formed on the electrode (the anode 36 in the present embodiment) of the organic EL element 31 that is formed over the whole surface of the substrate main body 35. The pedestal 34 is provided one by one in an island shape at the respective area (pixel area) 40 sectioned by the bank 32 and is arranged at a predetermined distance from the bank 32. In the present embodiment, the pedestal 34 is formed in a shape forward tapered in a direction away from the substrate main body 35. In other words, the pedestal 34 is configured to narrow as away from the substrate main body 35.

The bank 32 and the pedestal 34 are formed so as to have substantially the same height from the substrate main body 35. In the present embodiment, the bank 32 and the pedestal 34 are formed on the same surface, and therefore, the bank 32 and the pedestal 34 are formed so as to have the same thickness.

The organic EL element 31 includes a pair of electrodes and a light-emitting layer 38 between the electrodes. The pair of electrodes includes the anode 36 and a cathode 37. At a position between the electrodes, a layer different from the light-emitting layer 38 may be provided, and a plurality of light-emitting layers may also be provided. Examples of the layer provided between the light-emitting layer and the anode include a hole injection layer, a hole transport layer and an electron block layer. Examples of the layer provided between the light-emitting layer and the cathode include an electron injection layer, an electron transport layer and a hole block layer. In the present embodiment, a hole injection layer 39 is provided between the anode 36 and the light-emitting layer 38. In other words, the organic EL element 31 of the present embodiment is structured by stacking the anode 36, the hole injection layer 39, the light-emitting layer 38 and the cathode 37 in this order on the substrate main body 35.

The anode 36 is realized with a conductive film formed on the whole surface of the substrate main body 35. In other words, in the present embodiment, each anode 36 of the plurality of organic EL elements 31 is structured with a common electrode comprising the conductive film formed on the whole surface of the substrate main body 35. Accordingly, the anodes 36 of the organic EL elements 31 are electrically connected with each other. When the organic EL element 31 has a structure in which light output from the organic EL element 31 is extracted through the substrate main body 35, the anode 36 is formed of a conductive film having light transparency. For example, the anode 36 having light transparency can be formed using a thin film of indium oxide, zinc oxide, tin oxide, ITO, indium zinc oxide (abbrev.:IZO), gold, platinum, silver, copper, and the like.

The hole injection layer 39 is formed on the surface area of the anode 36 where the bank 32 and the pedestal 34 are not provided. The hole injection layer 39 is made of inorganic substances or organic substances. Specifically, the hole injection layer 39 may be formed using an oxide such as vanadium oxide, molybdenum oxide, ruthenium oxide, and aluminum oxide, phenylamines, starburst-type amines, phthalocyanines, amorphous carbon, polyaniline, polythiophene derivatives, and the like.

The light-emitting layer 38 is formed on the hole injection layer 39. The light-emitting layer 38 includes any one of a low molecular organic substance and a high molecular organic substance or both. When the light-emitting layer 38 is formed by a coating method, from the viewpoint of solubility in solvents, the material of the light-emitting layer 38 is preferably a polymer compound, and more preferably a polymer compound having a polystyrene equivalent number average molecular weight of 10³ to 10⁸. Examples of the material of the light-emitting layer 38 include the following pigment-based materials, metal complex-based materials, polymer-based materials, and the like.

### (Pigment-based materials)

Examples of the pigment-based materials include cyclopentamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal complex-based materials)

Examples of the metal complex-based materials include metal complexes having, as a central metal, a rare-earth metal such as Tb, Eu and Dy, Al, Zn, Be, Ir, Pt, or the like and having, as a ligand, a structure of oxadiazole, thiadiazole, phenylpyridine, phenylbenzimidazole, quinoline, or the like. Examples of the metal complex-based materials include metal complexes that emit light from the triplet excited state such as iridium complexes and platinum complexes; alumiquinolinol complexes; benzoquinolinole beryllium complexes; benzoxazolyl zinc complexes; benzothiazole zinc complexes; azomethyl zinc complexes; porphyrin zinc complexes; and phenanthroline europium complexes.

### (Polymer-based materials)

Examples of the polymer-based materials include polyparaphenylene vinylene derivatives, polythiophene derivatives, polyparaphenylene derivatives, polysilane derivatives, polyacetylene derivatives, polyfluorene derivatives, polyvinyl carbazole derivatives, and materials obtained by polymerizing the pigment-based materials or the metal complex-based light-emitting materials described above.

The cathode 37 is formed on the light-emitting layer 38. The cathode 37 is made of, for example, alkali metals, alkaline-earth metals, transition metals, and Group III-B metals. Examples of the materials used for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium; alloys of two or more of the above metals; alloys of one or more of the above metals and one or more of gold, silver, platinum, copper, manganese, titanium, cobalt, nickel, tungsten and tin; and graphite or graphite intercalation compounds.

The first connecting electrode 33 is formed on the pedestal 34. In the present embodiment, the first connecting electrode 33 is formed so as to extend to the cathode 37 and cover the pedestal 34. In other words, the first connecting electrode 33 and the cathode 37 are integrally formed.

Although a conductive film 41 is provided on the surface of the bank 32 as illustrated in FIG. 1, the film is merely provided as an additional component in a manufacturing process in the present embodiment and is not a member essential to the display panel 1. The conductive film 41 provided on the surface of the bank 32 and the cathode 37 are electrically insulated, and therefore, the cathode 37 of each of the organic EL elements 31 is electrically separated from each other.

The display panel 1 further includes a bonding means for bonding the driving substrate 20 and the display device substrate 30 together. The driving substrate 20 and the display device substrate 30 are bonded together with a bonding member arranged so as to surround an area where the organic EL elements 31 are formed (display area) between the driving substrate 20 and the display device substrate 30. The bonding member is made of, for example, resins or glass. For the bonding means, a vise, a clamp, or other equipment that presses the driving substrate 20 against the display device substrate 30 may also be used.

A manufacturing method of the display panel 1 is described below.

The driving substrate 20 is prepared. The driving substrate 20 can be manufactured by using a publicly known semiconductor manufacturing technique and can be manufactured by arranging the second connecting electrode 24 at a position corresponding to the pedestal 34. The driving substrate 20 may also be obtained from the market.

Subsequently, the display device substrate 30 is prepared. A manufacturing method of the display device substrate 30 of the present embodiment comprises: a step of forming a bank and a pedestal comprising forming the bank 32 sectioning the plurality of organic EL elements 31 on the substrate main body 35 and forming the protruding pedestal 34 on the substrate main body 35; a step of forming the plurality of organic EL elements 31 on the substrate main body 35; and a step of forming the first connecting electrode 33 extending from the organic EL element and over the pedestal 34.

The substrate main body 35 is prepared. For the substrate main body 35, a substrate that is not deformed during the process of manufacturing the organic El element 31, such as a glass substrate and a plastic substrate, is suitably used.

Subsequently, the anode 36 is formed over the whole surface of the substrate main body 35. The anode 36 may be formed by a vacuum deposition method, a sputtering method, an ion plating method, a plating method, or the like.

### (Step of forming bank and pedestal)

In the step of forming a bank and a pedestal, a bank and an electrode pedestal are formed by a single photolithography step.

Specifically, a negative photosensitive resin composition is applied onto the whole surface of the substrate main body (the whole surface of the anode 36 in the present embodiment) to form a film of the negative photosensitive resin composition on the whole surface of the anode 36. The film is formed by a spin coating method, a slit coating method, or the like. Examples of the negative photosensitive resin include a novolac resin, an acrylic resin, and a polyimide resin. After the film is formed, the film is generally pre-baked.

Subsequently, an exposing step is performed by applying light to a portion where the bank 32 is to be formed and a portion where the pedestal 34 is to be formed, on the formed film. Specifically, a first exposure is performed in a grid pattern for the portion where the bank 32 is to be formed, and a second exposure is performed in an island shape for the portion where the pedestal 34 is to be formed. The portion irradiated with light at the first exposure is different from that at the second exposure, and therefore, different masks are used to perform such exposures. In the exposing step, the portion where the pedestal 34 is to be formed is irradiated with larger amount of light than the portion where the bank 32 is to be formed. More specifically, the amount of light irradiation per unit area at the first exposure is set to be smaller than the amount of light irradiation per unit area at the second exposure. The amount of light irradiation can be adjusted by adjusting irradiation time and irradiation strength. The first exposure and the second exposure may be changed in their order.

In the exposing step, one surface of the film is irradiated with light, and thus, the film is gradually exposed and cured from the one surface. Therefore, when the amount of light irradiation is small, a surface portion is mainly cured, and after the development, a backward tapered structural object is formed in a direction away from the substrate main body 35. In contrast, when the amount of light irradiation is large, the film is cured from the one surface toward the other surface, and thus, after the development, a forward tapered structural object is formed in a direction away from the substrate main body 35.

In the present embodiment, since the amount of light irradiation is small at the first exposure, a surface portion of the film of the negative photosensitive resin is mainly cured, and after the development, the bank 32 is formed in a shape inversely tapered in a direction away from the substrate main body 35. On the other hand, the amount of light irradiation is large at the second exposure, therefore, the whole area in the thickness direction of the film of the negative photosensitive resin is exposed and cured, and after the development, the pedestal 34 is formed in a shape forward tapered in a direction away from the substrate main body 35.

After the exposure, post exposure bake is generally performed for development. Examples of an etchant for development include a TMAH (tetramethylammonium hydroxide ) aqueous solution and a potassium hydroxide aqueous solution. After the development, a rinse and post-bake are performed. As a result, the bank 32 and the pedestal 34 that have the same height from the substrate main body 35 can be formed in a shape inversely tapered and a shape forward tapered, respectively. In such a manner, the bank 32 and the pedestal 34 can be formed by a single photolithography step, and therefore, the number of processes can be reduced as compared with the case where a bank and a pedestal are separately formed at different processes.

When layers (the hole injection layer 39 and the light-emitting layer 38 in the present embodiment) located between the electrodes of the organic EL element 31 are formed by a coating method, the coating liquid is supplied into the predetermined area (pixel area) 40 sectioned by the bank 32. The bank 32 serves as a partition for keeping the supplied coating liquid within the pixel area 40. For firmly keeping the coating liquid within the pixel area 40, it is preferable that the bank 32 has lyophobic properties to the coating liquid. An example of a method for imparting lyophobic properties to the bank 32 include a method of performing CF₄ plasma treatment for hydrophobizing organic substances. When CF₄ plasma treatment is performed, lyophobic properties are imparted to the pedestal 34 as well as the bank 32.

### (Forming method of hole injection layer)

The hole injection layer 39 is formed by a coating method, a vacuum deposition method, a sputtering method, an ion plating method, or the like. Examples of the coating method include a spin coating method, a casting method, a micro-gravure coating method, a gravure coating method, a bar coating method, a roll coating method, a wire bar coating method, a dip coating method, a spray coating method, a screen printing method, a flexo printing method, an offset printing method, and an ink-jet printing method. Specifically, the hole injection layer 39 can be obtained by applying the coating liquid containing the material constituting the hole injection layer as mentioned above onto the surface of the anode 36 and then drying the liquid. The coating liquid is repelled by the bank 32 and the pedestal 34 because the bank 32 and the pedestal 34 have lyophobic properties to the coating liquid. Therefore, the coating liquid is not applied onto the bank 32 and the pedestal 34, and as a result, the hole injection layer 39 is not formed on the bank 32 and the pedestal 34 (see FIG. 1) .

### (Forming method of light-emitting layer)

The light-emitting layer 38 can be formed in a manner similar to the hole injection layer 39.

### (Forming method of cathode)

The cathode 37 can be formed by a vacuum deposition method, a sputtering method, a lamination method, or the like. In the present embodiment, the material of the cathode 37 is deposited so as to cover one surface of the substrate main body 35 from one side of the substrate main body 35 in the thickness direction. Consequently, a conductive film is formed also on the surface of the bank 32. The bank 32 is in a shape inversely tapered, therefore, the conductive film on the bank 32 and the cathode 37 are cut off from each other as illustrated in FIG. 1 and they are electrically insulated. Therefore, the cathodes 37 of the organic EL elements 31 are insulated from each other by the bank 32. During the formation of the cathode 37, the conductive film serving as the first connecting electrode 33 is formed also on the pedestal 34. Since the pedestal 34 is in a shape forward tapered, the conductive film is formed also at the side of the pedestal 34 and thus the first connecting electrode 33 is continuously and integrally formed with the cathode 37. Therefore, the first connecting electrode 33 and the cathode 37 are electrically connected. The cathode 37 is formed in such a manner to form the organic EL element 31, and thus, the display device substrate 30 can be manufactured.

### (Bonding process)

The driving device substrate 20 and the display device substrate 30 are bonded together. Such bonding is performed by, for example: arranging a bonding member at the periphery of the surface of the driving device substrate 20 or the display device substrate 30; arranging the driving device substrate 20 so as to face the display device substrate 30 so that the pedestal 34 of the display device substrate 30 overlaps the second connecting electrode 24 of the driving device substrate 20; pressing the driving device substrate 20 against the display device substrate 30; and then curing the bonding member as needed.

For the bonding member, a photosensitive resin, a thermosetting resin, a frit member containing a low-melting-point glass powder, or the like. When the photosensitive resin is used for the bonding member, both substrates can be bonded together by radiating light after the pressing. When the thermosetting resin is used for the bonding member, both substrates can be bonded together by applying heat after the pressing. When the frit member is used, both substrates can be bonded together by, for example, irradiating glass with laser light or the like to melt the glass and then cooling it. Glass has higher gas barrier properties than resins, and thus, the frit member is preferably used as the bonding member for air-tightly sealing the space between the driving device substrate 20 and the display device substrate 30.

It is preferable that the driving device substrate 20 is pressed against the display device substrate 30 in a vacuum atmosphere or a nitrogen atmosphere. When pressing is performed in a vacuum atmosphere or a nitrogen atmosphere, the space surrounded by the driving device substrate 20, the display device substrate 30 and a sealing member becomes a vacuum atmosphere or a nitrogen atmosphere. Therefore, it is possible to suppress deterioration of the elements formed at the driving device substrate 20 and the display device substrate 30. When the driving device substrate 20 is pressed against the display device substrate 30 in a vacuum atmosphere, for example, a pressure from atmospheric pressure is added after the pressing, so that the connection between the first connecting electrode 33 and the second connecting electrode 24 is further ensured. Therefore, pressing in a vacuum atmosphere is preferable. When pressing in a nitrogen atmosphere, it is preferable that the bonding member is cured in a state where a pressure is applied in such a direction that the driving device substrate 20 is in close contact with the display device substrate 30. As a result of this, the connection between the first connecting electrode 33 and the second connecting electrode 24 can be further ensured.

The driving device substrate 20 may be pressed against the display device substrate 30 using a holding body such as a clamp that holds the driving device substrate 20 and the display device substrate 30 without using any bonding member.

In the present embodiment, the bank 32 and the pedestal 34 have the same height. Therefore, when the driving device substrate 20 is pressed against the display device substrate 30, the driving substrate 20 may come into contact with not only the first connecting electrode 33 formed on the pedestal 34 but also the conductive film 41 formed on the bank 32. However, the conductive film 41 formed on the bank 32 is electrically insulated from the cathode 37, and the insulating film 22 is formed at a portion with which the conductive film 41 formed on the bank 32 comes into contact. Therefore, even when the driving substrate 20 comes into contact with the conductive film 41 formed on the bank 32, the electrical structure of the display panel 1 is not affected.

To reduce contact resistance between the first connecting electrode 33 and the second connecting electrode 24, it is preferable that the first connecting electrode 33 comes in contact with the second connecting electrode 24 with a predetermined pressure being applied. The driving device substrate 20 is preferably pressed against the display device substrate 30 at a pressure to the extent that the pedestal 34 is compressed by a predetermined height.

A display device can be manufactured by mounting the display panel 1 thus manufactured on a housing together with a speaker, a tuner, a driver, etc.

Although the organic EL element formed by stacking the anode, the hole injection layer, the light-emitting layer and the cathode sequentially from the substrate main body side is described above, the layer structure of the organic EL element is not limited to this aspect as described above. The organic EL element may be of a top emission type or of a bottom emission type. The layer structures and each layer of the organic EL element applicable to the present invention are exemplified below.

Examples of the layer provided between the cathode and the light-emitting layer include an electron injection layer, an electron transport layer, and a hole block layer. When a single layer is provided between the cathode and the light-emitting layer, the layer is called the electron injection layer. When both of the electron injection layer and the electron transport layer are provided between the cathode and the light-emitting layer, a layer in contact with the cathode is called the electron injection layer, and a layer except for the electron injection layer is called the electron transport layer.

The electron injection layer is a layer having function to improve electron injection efficiency from the cathode. The electron transport layer is a layer having function to improve electron injection from the cathode, the electron injection layer, or the electron transport layer closer to the cathode. The hole block layer is a layer having function to block the transport of holes. When any one of the electron injection layer and the electron transport layer or both have function to block the transport of holes, such layer may also serve as the hole block layer.

The function of the hole block layer to block the transport of holes can be confirmed by, for example, preparing an element in which only hole current flows and confirming an effect of blocking holes based on the reduction of the current value.

Examples of the layer provided between the anode and the light-emitting layer include a hole injection layer, a hole transport layer, and an electron block layer. When both of the hole injection layer and the hole transport layer are provided between the anode and the light-emitting layer, a layer in contact with the anode is called the hole injection layer, and a layer except for the hole injection layer is called the hole transport layer.

The hole injection layer is a layer having function to improve hole injection efficiency from the anode. The hole transport layer is a layer having function to improve hole injection from the anode, the hole injection layer, or the hole transport layer closer to the anode. The electron block layer is a layer having function to block the transport of electrons. When any one of the hole injection layer and the hole transport layer or both have function to block the transport of electrons, such layer may also serve as the electron block layer.

The function of the electron block layer to block the transport of electrons can be confirmed by, for example, preparing an element in which only electron current flows and confirming an effect of blocking electrons based on the reduction of the current value.

The electron injection layer and the hole injection layer may be collectively called charge injection layers, and the electron transport layer and the hole transport layer may be collectively called charge transport layers.

Applicable layer structures of the organic EL element are exemplified below.
a) anode/light-emitting layer/cathode
b) anode/hole injection layer/light-emitting layer/cathode
c) anode/hole injection layer/light-emitting layer/electron injection layer/cathode
e) anode/hole injection layer/light-emitting layer/electron transport layer/cathode
f) anode/hole injection layer/light-emitting layer/electron transport layer/electron injection layer/cathode d) anode/hole transport layer/light-emitting layer/cathode e) anode/hole transport layer/light-emitting layer/electron injection layer/cathode
f) anode/hole transport layer/light-emitting layer/electron transport layer/cathode
g) anode/hole transport layer/light-emitting layer/electron transport layer/electron injection layer/cathode
h) anode/hole injection layer/hole transport layer/light-emitting layer/cathode
i) anode/hole injection layer/hole transport layer/light-emitting layer/electron injection layer/cathode
j) anode/hole injection layer/hole transport layer/light-emitting layer/electron transport layer/cathode
k) anode/hole injection layer/hole transport layer/light-emitting layer/electron transport layer/electron injection layer/cathode
l) anode/light-emitting layer/electron injection layer/cathode
m) anode/light-emitting layer/electron transport layer/cathode
n) anode/light-emitting layer/electron transport layer/electron injection layer/cathode (wherein a symbol "/" indicates that the layers across the symbol "/" are adjacently stacked. The same shall apply hereinafter.)

The organic EL element of the present embodiment may include two or more light-emitting layers. When a stacked body interposed between an anode and a cathode in any one of the layer structures of a) to n) described above is indicated by a "repeating unit A", an example of the organic EL element having two light-emitting layers may include a layer structure of the following o). o) anode/(repeating unit A)/charge generation layer/(repeating unit A)/cathode

When "(repeating unit A)/charge generation layer" is indicated by a "repeating unit B", an example of the organic EL element having three or more light-emitting layers may include a layer structure of the following p). p) anode/(repeating unit B)x/(repeating unit A)/cathode

In this structure, a symbol "x" is an integer of two or more, and (repeating unit B)x indicates a stacked body in which the repeating unit B is stacked x times.

The charge generation layer is a layer that generates holes and electrons when electric field is applied thereto. An example of the charge generation layer include a thin film of vanadium oxide, indium tin oxide (Abbrev.:ITO), molybdenum oxide, or the like.

Although the anode is arranged closer to the substrate main body 35 than the cathode in the embodiment described above, the layer structure may be reversed such that the cathode is arranged closer to the substrate main body 35 than the anode.

In the embodiment described above, the layers (the hole injection layer and the light-emitting layer) provided between the electrodes is formed by a coating method. However, a thin film made of, for example, low molecular organic substances, low molecular inorganic substances, or the like may also be formed by vapor deposition, etc. In this case, it is expected that the hole injection layer, the light-emitting layer, and the like are formed also on the pedestal 34. However, these layers are separated by the bank 32 as with the cathode 37 described above, and thus, the driving of each organic EL element is not affected.

Furthermore, although the bank 32 is formed in a shape inversely tapered in a direction away from the substrate main body 35 in the embodiment described above, both the bank and the pedestal may also be formed in shapes forward tapered in a direction away from the substrate main body 35 in another embodiment. When the cathode 37 is formed over the whole surface of the substrate while the bank is formed in a shape forward tapered, the cathodes of the organic EL elements 31 come to conduct each other. For this reason, without forming the cathode over the whole surface, the cathode 37 may be formed selectively on each of organic EL elements 31 except for the surface of the bank by, for example, using a predetermined mask. When both the bank and the pedestal are formed in shapes forward tapered in a direction away from the substrate main body 35, the exposing step does not need to be performed twice as in the embodiment described above, and the exposing step may be performed once.

### Industrial Applicability

According to the present invention, a bank and a pedestal having the same height are provided. It is difficult to form members having different structures at a single process, and the difficulty grows in accordance with the increase in structural difference. The present invention can reduce the structural difference by aligning the heights of the bank and the pedestal and facilitate the formation of the bank and the pedestal at a single process. Thus, a display device substrate that can be manufactured by a simple process can be realized by aligning the heights of the bank and the pedestal.

## Claims

1. A display device substrate to be bonded to a driving substrate provided with a driving circuit for driving a plurality of organic electroluminescent elements, the display device substrate comprising:
a substrate main body;
a plurality of organic electroluminescent elements provided on the substrate main body;
a bank sectioning the plurality of organic electroluminescent elements on the substrate main body;
a protruding pedestal provided on the substrate main body; and
a first connecting electrode arranged so as to extend from the organic electroluminescent element and over the pedestal, wherein
in a state where the display device substrate has been bonded to the driving substrate, the pedestal is arranged at a position where the first connecting electrode arranged on the pedestal is connected with a second connecting electrode that the driving circuit has, and
the bank and the pedestal have the same height.

2. The display device substrate according to claim 1, wherein
the pedestal is in a shape forward tapered in a direction away from the substrate main body, and
the bank is in a shape inversely tapered in a direction away from the substrate main body.

3. A display panel comprising:
the display device substrate of claim 1 or 2; and
a driving substrate provided with a driving circuit for driving the plurality of organic electroluminescent elements provided in the display device substrate, wherein
the displaying substrate and the driving substrate are bonded together so that the first connecting electrode may be connected with a second connecting electrode that the driving circuit has.

4. A display device comprising the display panel of claim 3.

5. A method for manufacturing a display device substrate to be bonded to a driving substrate provided with a driving circuit for driving a plurality of organic electroluminescent elements, the method comprising:
a step of forming a bank and a pedestal comprising forming a bank and a protruding pedestal on the substrate main body, the bank being to section the plurality of organic electroluminescent elements on the substrate main body;
a step of forming the plurality of organic electroluminescent elements on the substrate main body; and
a step of forming a first connecting electrode extending from the organic electroluminescent element and over the pedestal, wherein
in the step of forming a bank and a pedestal, the pedestal is formed at a position where the first connecting electrode arranged on the pedestal is connected with a second connecting electrode that the driving circuit has in a state where the display device substrate has been bonded to the driving substrate, the bank having the same height as the pedestal is formed, and the bank and the pedestal are formed by a single photolithography step.

6. The method for manufacturing a display device substrate according to claim 5, wherein in the step of forming a bank and a pedestal, the pedestal is formed in a shape forward tapered in a direction away from the substrate main body, and the bank is formed in a shape inversely tapered in a direction away from the substrate main body.

7. The method for manufacturing a display device substrate according to claim 6, wherein
the single photolithography step comprises a film forming step of applying a negative photosensitive resin composition onto the substrate main body to form a film, an exposing step of applying light to a portion where the bank is to be formed and a portion where the pedestal is to be formed, on the film formed in the film forming step, and a developing step, and
in the exposing step, the portion where the pedestal is to be formed is irradiated with larger amount of light than the portion where the bank is to be formed.
